(19) Europäisches Patentamt
European Patent Office
Office européen des brevets

(11) **EP 1 260 021 B1**

(12) **EUROPÄISCHE PATENTSCHRIFT**

(45) Veröffentlichungstag und Bekanntmachung des Hinweises auf die Patenterteilung:
**18.10.2006 Patentblatt 2006/42**

(21) Anmeldenummer: **01915336.0**

(22) Anmeldetag: **14.03.2001**

(51) Int Cl.:
***H03J 3/20*** (2006.01)

(86) Internationale Anmeldenummer:
**PCT/EP2001/002871**

(87) Internationale Veröffentlichungsnummer:
**WO 2001/078231 (18.10.2001 Gazette 2001/42)**

(54) **BAUELEMENT MIT EINER INTEGRIERTEN HOCHFREQUENZSCHALTUNG**

STRUCTURAL ELEMENT WITH AN INTEGRATED HIGH-FREQUENCY CIRCUIT

COMPOSANT POURVU D'UN CIRCUIT HAUTE FREQUENCE INTEGRE

(84) Benannte Vertragsstaaten:
**DE FR GB IT**

(30) Priorität: **10.04.2000 EP 00107704**

(43) Veröffentlichungstag der Anmeldung:
**27.11.2002 Patentblatt 2002/48**

(73) Patentinhaber: **Infineon Technologies AG**
**81669 München (DE)**

(72) Erfinder:
• **LOSEHAND, Reinhard**
**80637 München (DE)**
• **WERTHMANN, Hubert**
**81247 München (DE)**
• **BARTL, Ulf**
**81549 München (DE)**

(74) Vertreter: **Epping - Hermann - Fischer**
**Ridlerstrasse 55**
**80339 München (DE)**

(56) Entgegenhaltungen:
WO-A-98/28759      GB-A- 2 120 478
US-A- 3 909 748    US-A- 4 216 451
US-A- 4 573 025    US-A- 5 745 012
US-A- 5 936 474

**Beschreibung**

Die Erfindung betrifft ein Bauelement mit einer integrierten Hochfrequenzschaltung, die einen Schwingkreis mit einer Oszillatorkapazität aufweist, deren Wert für einen vorgegebenen Frequenzbereich durch eine Abstimmdiode einstellbar ist.

Bisher werden im Frequenzbereich von 1,5 bis 3 Gigahertz keine integrierten Bauelemente für Schwingkreise oder Signalgeneratoren verwendet. Derzeit kommen entweder diskrete Spulen und Kapazitätsdioden zum Einsatz oder es werden Module aus mehreren integrierten Bauelementen in einem Gehäuse verwendet.

Es besteht jedoch Bedarf an integrierten Bauelementen mit Schwingkreisen oder Signalgeneratoren. Insbesondere werden abstimmbare, spannungsgesteuerte integrierte Bauelemente benötigt. Die üblichen Schaltungen für spannungsgesteuerte Schwingkreise enthalten zumindest eine Abstimmdiode, an denen eine gegen die Flußrichtung gepolte Gleichspannung als Vorspannung anliegt. Die Sperrschichtkapazität der Abstimmdiode ist dann eine monotone Funktion dieser Vorspannung. Der Schwingkreis verfügt daher über eine spannungsgeregelte Kapazität, mit der die Resonanzfrequenz des Schwingkreises eingestellt werden kann. Die Vorspannung dient dabei zum Durchfahren des nutzbaren Frequenzbandes.

Die Spezifikation eines fertigen integrierten Bauelements mit einem Schwingkreis enthält auch einen definierten Zusammenhang zwischen Vorspannung und Resonanzfrequenz. Da jedoch die elektrischen Eigenschaften aller Schaltungselemente in einem Toleranzbereich schwanken können, muß die Möglichkeit bestehen, die Resonanzfrequenz des Schwingkreises abzugleichen.

Aus dem Buch "Microwave and Wireless Synthesizers" von Ulrich L. Rohde, New York 1997, Seiten 62 und 63 ist bekannt, die Feinsteuerung eines Schwingkreises durch eine Abstimmdiode vorzunehmen, an der eine gegen die Flußrichtung gepolte Gleichspannung als Vorspannung anliegt. Parallel zu der Abstimmdiode sind zwei gegeneinander gepolte, zweite und dritte Abstimmdioden vorgesehen, zwischen denen eine Gleichspannung als Vorspannung anliegt, durch die eine Grobsteuerung der Resonanzfrequenz des Schwingkreises vorgenommen werden kann.

Des weiteren sind aus GB-A-2 120 478 und US-A-5 936 474 spannungsgesteuerte Oszillatoren bekannt, die eine Parallelschaltung eines Schwingkreises mit Abstimmdioden und eines geschalteten Kondensatornetzwerks aufweisen.

Ausgehend von diesem Stand der Technik liegt der Erfindung die Aufgabe zugrunde, ein integriertes Bauelement mit einem abstimmbaren und abgleichbaren, spannungsgesteuerten Schwingkreis zu schaffen.

Diese Aufgabe wird erfindungsgemäß dadurch gelöst, daß die herstellungsbedingten Abweichungen in der Resonanzfrequenz des Schwungkreises durch ein über eine Koppelkapazität an den Schwingkreis angekoppeltes Leiternetzwerk kompensierbar ist, das zwischen Längsleitungen in Reihe geschaltete Querdioden und Querkapazitäten aufweist, die jeweils durch Einstellen des Arbeitspunkts der Querdioden mit Hilfe eines schaltbaren Gleichspannungsnetzes parallel zur Oszillatorkapazität zuschaltbar sind.

Bei dem Bauelement gemäß der Erfindung werden die Querkapazitäten durch Einstellen des Arbeitspunkts der Querdioden parallel zur Oszillatorkapazität zugeschaltet. Im eigentlichen Leiternetzwerk, das dem Abgleich dient, finden sich somit keine Schaltelemente wie Schmelzbrücken oder Transistoren, deren elektrische Eigenschaft die Wirkung des Leiternetzwerkes beeinträchtigen können. Denn sowohl Transistoren als auch Schmelzbrücken weisen im leitenden Zustand ein verhältnismäßig hohen ohmschen Widerstand auf, der die Güte des Leiternetzwerks und damit des Schwingkreises senkt. Demgegenüber weisen Dioden im leitenden Zustand einen niedrigen ohmschen Widerstand auf. Beim Bauelement gemäß der Erfindung werden daher die Schaltfunktion im Leiternetzwerk durch die Querdioden bewerkstelligt. Die zum Einstellen des Arbeitspunkts der Querdioden erforderlichen Schaltelemente befinden sich im Gleichspannungsnetz und beeinträchtigen somit nicht die Güte des Leiternetzwerks.

Weitere zweckmäßige Ausgestaltungen der Erfindung sind Gegenstand der abhängigen Ansprüche.

Nachfolgend wird ein Ausführungsbeispiel der Erfindung anhand der beigefügten Zeichnung erläutert. Es zeigt:

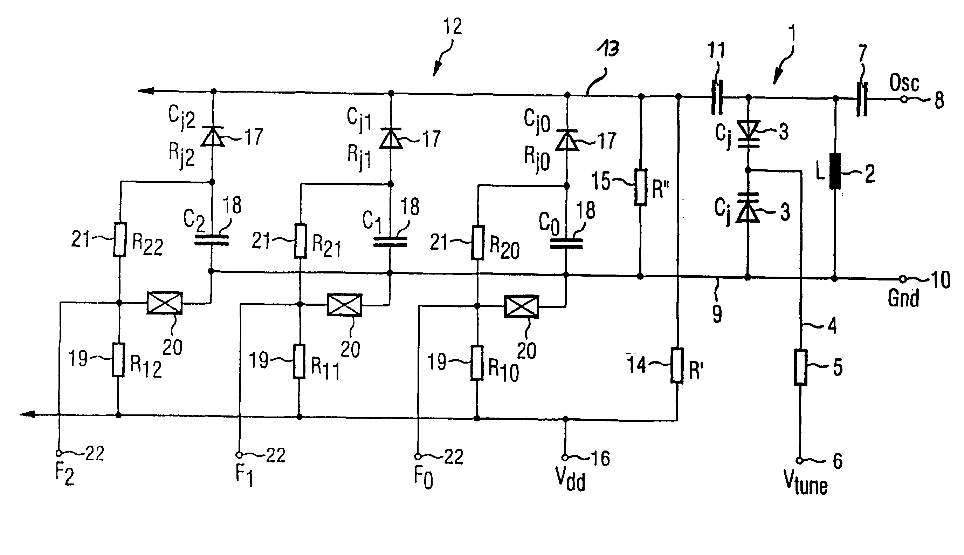

Figur 1   eine Schaltungsanordnung für ein integriertes Bauelement mit einem Schwingkreis, der mit einem Leiternetzwerk abgleichbar ist.

Die Schaltungsanordnung aus Figur 1 weist einen Schwingkreis 1 auf, der eine Induktivität 2 und ein Paar von gegeneinander gepolten, in Reihe geschalteten Kapazitätsdioden 3 aufweist. Zwischen den Kapazitätsdioden 3 ist eine Abstimmleitung 4 angeschlossen, die über ein Vorwiderstand 5 zu einem Abstimmeingang 6 führt. Der Schwingkreis 1 ist über einen äußeren Koppelkondensator 7 mit einem Oszillatorausgang 8 verbunden. Außerdem ist eine Masseleitung 9 zu einem Masseanschluß 10 geführt.

Durch eine am Abstimmeingang 6 anliegende Abstimmspannung $V_{tune}$ kann die Kapazität der Kapazitätsdioden 3 verändert werden. Dementsprechend verschiebt sich die Resonanzfrequenz des Schwingkreises 1. Die Herstellung der Kapazitätsdioden 3 führt jedoch im allgemeinen zu Schwankungen in den elektrischen Eigenschaften der Kapazitätsdioden 3. Um einen spezifizierten Zusammenhang zwischen der Resonanzfrequenz des Schwingkreises und der am Abstimmeingang 6 anliegenden Abstimmspannung $V_{tune}$ herzustellen, ist es daher erforderlich, eine Abgleichmöglichkeit vorzusehen.

Bei der Schaltungsanordnung gemäß Figur 1 wird der Schwingkreis 1 mit Hilfe eines Leiternetzwerk 12 bewerkstelligt, das über einen inneren Koppelkondensator 11 an den Schwingkreis 1 angeschlossen ist. Das Leiternetzwerk 12 weist eine zum Koppelkondensator 11 führende Abgleichleitung 13 auf, deren Potential durch ohmsche Widerstände 14 und 15 mit dem Wert R' und R" auf einen Wert zwischen dem Potential der Masseleitung 9 und dem Potential einer Versorgungsspannung $V_{dd}$ gehalten ist. Der von ohmschen Widerständen 14 und 15 gebildete Spannungsteiler ist zwischen der Masseleitung 9 und einem Versorgungsspannungseingang 16 geschaltet.

An die Abgleichleitung 13 sind die Kathoden von PIN-Dioden 17 angeschlossen. Die PIN-Dioden 17 sind in Reihe mit Abgleichkondensator 18 geschaltet, die mit der Masseleitung 9 verbunden sind. Die Anoden der PIN-Dioden 17 können über Pull-Up-Widerstände 19 und Schmelzbrücken 20 wahlweise auf das Potential der am Versorgungsspannungseingang 16 anliegenden Versorgungsspannung oder auf das Potential der Masseleitung 9 gelegt werden. Insbesondere wenn die Schmelzbrücken 20 geschlossen sind, werden die Abgleichkondensatoren 18 von der Schmelzbrücke 20 und Parallelwiderständen 21 überbrückt.

Schließlich sind Schmelzstromeingänge 22 vorgesehen, durch die ein Schmelzstrom durch die Schmelzbrücken 20 hindurch zur Masseleitung 9 geführt werden kann.

Die Funktion des Leiternetzwerks 12 wird nachfolgend anhand eines Elements des Leiternetzwerks 12 erläutert.

Wie bereits erwähnt, liegt die Abgleichleitung 13 auf einem Potential, daß zwischen dem Potential der Masseleitung 9 und dem Potential der Versorgungsspannung $V_{dd}$ liegt. Falls die Schmelzbrücke 20 geschlossen ist, wird die Anode der zugeordneten PIN-Diode 17 auf das Potential der Masseleitung 9 gezogen. Dadurch ist die PIN-Diode 17 in Sperrichtung gepolt. Dadurch wirkt die PIN-Diode wie ein Kondensator, dessen Kapazität nahezu unabhängig vom Wert der über der PIN-Diode 17 abfallenden Gleichspannung ist. Hochfrequenztechnisch liegen zwei in Reihe geschaltete Kapazitäten vor. Falls der Abgleichkondensator 18 und die PIN-Diode 17 jeweils den Kapazitätswert C aufweisen, ergibt sich somit eine Gesamtkapazität mit dem Wert C/2.

Wenn umgekehrt die Schmelzbrücke 20 offen ist, zieht der Pull-Up-Widerstand 19 und der Parallelwiderstand 21 die Anode der PIN-Diode 17 auf das Potential der Versorgungsspannung $V_{dd}$. Dadurch wird die PIN-Diode 17 vorwärts gepolt und wirkt hochfrequenztechnisch nur noch als kleiner ohmscher Widerstand. Hochfrequenztechnisch wirkt daher nur noch die Kapazität des Abgleichkondensators 18. Die von der PIN-Diode 17 und dem Abgleichkondensator 18 gebildete Kette weist somit die Gesamtkapazität C auf.

Wenn nun n Elemente des Leiternetzwerks 12 in Parallelschaltung nebeneinander angeordnet werden, ist es möglich, $2^n$ verschiedene Resonanzen im Schwingkreis 1 zu erzeugen. Bei dem in Figur 1 dargestellten Ausführungsbeispiel sind die Kapazitäten des Abgleichkondensators 18 und der PIN-Diode 17 im ersten Element auf den Wert $C_0$ gesetzt worden. Im zweiten Element wurde die Kapazität $C_1$ des Abgleichkondensators 18 und der PIN-Diode 17 gleich $2C_0$ gesetzt. In der dritten Zelle schließlich wurden die Kapazitäten $C_2$ des Abgleichkondensators 18 und der PIN-Diode 17 gleich $4C_0$ festgesetzt. Damit sind die in der Tabelle 1 aufgeführten Werte für die Gesamtkapazität möglich.

Tabelle 1

| F2 | F1 | F0 | Gesamtkapazität |
|----|----|----|-----------------|
| 0 | 0 | 0 | $C_2+C_1+C_0=7C_0$ |
| 0 | 0 | 1 | $C_2+C_1+C_0/2=6.5C_0$ |
| 0 | 1 | 0 | $C_2+C_1/2+C_0=6C_0$ |
| 0 | 1 | 1 | $C_2+C_1/2+C_0/2=5.5C_0$ |
| 1 | 0 | 0 | $C_2/2+C_1+C_0=5C_0$ |
| 1 | 0 | 1 | $C_2/2+C_1+C_0/2=4.5C_0$ |
| 1 | 1 | 0 | $C_2/2+C_1/2+C_0=4C_0$ |
| 1 | 1 | 1 | $C_2/2+C_1/2+C_0/2=3,5C_0$ |

Nachfolgend wird ein Dimensionierungsbeispiel für die Schaltungsanordnung aus Fig. 1 angegeben. Der Schwingkreis 1 soll dabei auf eine Frequenz von 1 GHz ausgelegt sein. Zu diesem Zweck ist die Kapazität der Kapazitätsdioden 3 auf den Wert $C_j$ = 4 pF gesetzt. Die Induktivität 2 ist mit L = 8 nH dimensioniert.

Außerdem sind drei Schaltelemente vorgesehen. Die Abgleichkondensatoren 18 weisen in dem Dimensionierungsbeispiel die Werte $C_2$ = 1 pF, $C_1$ = 0,5 pF und $C_0$ = 0,25 pF auf. Die PIN-Dioden 17 verfügen über die Kapazitätswerte $C_{j2}$ = 1 pF, $C_{j1}$ = 0,5 pF und $C_{j0}$ = 0,25 pF. Dementsprechend sind die Werte der ohmschen Widerstände 14 und 15 sowie der Widerstände 19 und 21 gewählt. Die Widerstände 19 und 21 weisen folgende Werte auf: $R_{12}$ = 25 kOhm, $R_{11}$ = 50 kOhm, $R_{10}$ = 100 kOhm, $R_{22}$ = 25 kOhm, $R_{21}$ = 50 kOhm und $R_{20}$ = 100 kOhm. Der Wert des Widerstands 14 beträgt R' = 20 kOhm und der Widerstand des Widerstands 15 beträgt R'' = 10 kOhm, so daß sich bei einer Versorgungsspannung von $V_{DD}$ = 3 V auf der Abgleichleitung 13 ein Potential von $V_{high}$ = 1 V einstellt, wenn alle Schmelzbrücken 20 geschlossen sind. Falls dagegen alle Schmelzbrücken 20 geöffnet sind, ergibt sich auf der Abgleichleitung 13 ein Potential von $V_{high}$ = 1, 4 V.

Der Spannungsabfall an den PIN-Dioden 17 bei Stromeinprägung mit 10 µA in Flußrichtung ist 0,7 V und nur gering vom Strom abhängig, so daß sich die Ströme in $R_{1n}$ und $R_{2n}$ wie folgt berechnen: $I_n$ = ( $V_{DD}$ - 0,7 - $V_{high}$ ) / ( $R_{1n}$ + $R_{2n}$ ) . Demnach ergibt sich für die Ströme: $I_2$ = 20 µA, $I_1$ = 10 µA und $I_0$ = 5 µA.

Die PIN-Dioden 17 haben mit diesen Strömen folgende Serienwiderstände bei 1GHz: $R_{j2}$ = 1,25 Ohm, $R_{j1}$ = 2,5 Ohm und $R_{j0}$ = 5 Ohm. Die Serienwiderstände können in einen Parallelwiderstand zum Kondensator transformiert werden, der in jedem Zweig den gleichen Wert von etwa 20 kOhm liefert: $R_P$ = 1 / ($\omega^2$ $C^2$ $R_S$) = 20 kOhm, was einem Leitwert von $G_P$ = 0,00005 Siemens entspricht.

Die Hochfrequenzgüte der Schaltungsanornung kann nun durch Aufsummierung aller Parallelleitwerte für den Fall, daß alle Schmelzbrücken 20 offen sind, ermittelt werden:

$$Q = \omega\, C_{gesamt} \; / \; G_{p\ gesamt} = 2\pi \; * \; 10^9 \; * \; 3,3\ 10^{-12} \; / \; 0,00033 = 62$$

Für den Fall, daß alle Fuses geschlossen sind ergibt sich ein höherer Wert von etwa 100, weil hier die in Sperrichtung gepolten PIN-Dioden 17 weniger Verluste liefern

Es sei angemerkt, daß anstelle der Schmelzbrücken 20 auch Transistoren verwendet werden können. Zweckmäßigerweise werden diese Transistoren von einem Mikroprozessor gesteuert. Die genauen elektrischen Eigenschaften des jeweiligen Transistors sind dabei ohne Belang, da sich der Transistor im Gleichspannungsnetz befindet und die eigentliche Schaltungsfunktion von der PIN-Diode 17 ausgeführt wird.

Bezugszeichenliste

| | |
|---|---|
| 1 | Schwingkreis |
| 2 | Induktivität |
| 3 | Kapazitätsdioden |
| 4 | Abstimmleitung |
| 5 | Vorwiderstand |
| 6 | Abstimmeingang |
| 7 | Koppelkondensator |
| 8 | Oszillatorausgang |
| 9 | Masseleitung |
| 10 | Masseanschluß |
| 11 | Koppelkondensator |
| 12 | Leiternetzwerk |
| 13 | Abgleichleitung |
| 14 | ohmscher Widerstand |
| 15 | ohmscher Widerstand |
| 16 | Versorgungsspannungseingang |
| 17 | PIN-Diode |
| 18 | Abgleichkondensator |
| 19 | Pull-up-Widerstand |
| 20 | Schmelzbrücken |
| 21 | Parallelwiderstand |
| 22 | Schmelzstromeingänge |

**Patentansprüche**

**1.**  Bauelement mit einer integrierten Hochfrequenzschaltung, die einen Schwingkreis (1) mit einer Oszillatorkapazität (3) aufweist, deren Wert für einen vorgegebenen Frequenzbereich durch eine Abstimmdiode (3) einstellbar ist,
**dadurch gekennzeichnet, daß**
die herstellungsbedingten Abweichungen in der Resonanzfrequenz des Schwingkreises (1) durch ein über eine Koppelkapazität (11) an den Schwingkreis (1) angekoppeltes Leiternetzwerk (12) kompensierbar ist, das zwischen Längsleitungen (9, 13) in Reihe geschaltete Querdioden (17) und Querkapazitäten (18) aufweist, die jeweils durch Einstellen des Arbeitspunkts der Querdioden (17) mit Hilfe eines schaltbaren Gleichspannungsnetzes (19, 20, 21) parallel zur Oszillatorkapazität zuschaltbar sind.

**2.** Bauelement nach Anspruch 1,
**dadurch gekennzeichnet, daß**
die Längsleitungen von einer über die Koppelkapazität (11) an den Schwingkreis angeschlossenen Abgleichsleitung (13) und einer Masseleitung (9) gebildet sind.

**3.** Bauelement nach Anspruch 2,
**dadurch gekennzeichnet, daß**
das Potential der Abgleichleitung (13) durch einen Spannungsteiler (14, 15) auf einen Wert zwischen dem Potential einer Versorgungsspannung ($V_{dd}$) und dem Potential der Masseleitung (9) eingestellt ist.

**4.** Bauelement nach Anspruch 2 oder 3,
**dadurch gekennzeichnet, daß**
die Querdiode eine mit ihrer Kathode an die Abgleichleitung (13) angeschlossene Diode (17) ist.

**5.** Bauelement nach Anspruch 4,
**dadurch gekennzeichnet, daß**
die Querdiode eine PIN-Diode (17) ist.

**6.** Bauelement nach einem der Ansprüche 2 bis 5,
**dadurch gekennzeichnet, daß**
die Querkapazität ein an die Masseleitung angeschlossener Kondensator (18) ist.

**7.** Bauelement nach einem der Ansprüche 2 bis 6,
**dadurch gekennzeichnet, daß**
Anode jeder Querdiode (17) wahlweise über einen Pull-Up-Widerstand (19) auf das Potential einer Versorgungsspannung ($V_{dd}$) oder durch ein Schaltelement (20) auf das Potential der Masseleitung (9) einstellbar ist.

**8.** Bauelement nach Anspruch 7,
**dadurch gekennzeichnet, daß**
das Schaltelement eine Schmelzbrücke (20) ist.

**9.** Bauelement nach Anspruch 8,
**dadurch gekennzeichnet, daß**
die Schmelzbrücke (20) an einen Schmelzeingang (22) angeschlossen ist.

**10.** Bauelement nach Anspruch 9,
**dadurch gekennzeichnet, daß**
die Anode der Querdiode (17) durch einen Vorwiderstand (21) gesichert ist.

**Claims**

**1.** Component having an integrated high-frequency circuit, which has a resonant circuit (1) with an oscillator capacitance (3), whose value can be set for a predetermined frequency range by a tuning diode (3),
**characterized in that**
the production-related deviations in the resonant frequency of the resonant circuit (1) can be compensated for by a conductor network (12), which is coupled to the resonant circuit (1) via a coupling capacitance (11) and has, between series-path lines (9, 13), series-connected parallel-path diodes (17) and parallel-path capacitances (18), which can in each case be connected in parallel with the oscillator capacitance by setting of the operating point of the parallel-diodes (17) with the aid of a switchable DC voltage network (19, 20, 21).

**2.** Component according to Claim 1,
**characterized in that**
the series-path lines are formed by a trimming line (13), which is connected to the resonant circuit via the coupling capacitance (11), and a ground line (9).

**3.** Component according to Claim 2,
**characterized in that**
the potential of the trimming line (13) is set to a value between the potential of a supply voltage ($V_{dd}$) and the potential of the ground line (9) by a voltage divider (14, 15).

**4.** Component according to Claim 2 or 3,
**characterized in that**
the parallel-path diode is a diode (17) which is connected to the trimming line (13) by its cathode.

**5.** Component according to Claim 4,
**characterized in that**
the parallel-path diode is a PIN diode (17).

**6.** Component according to one of Claims 2 to 5,
**characterized in that**
the parallel-path capacitance is a capacitor (18) connected to the ground line.

**7.** Component according to one of Claims 2 to 6,
**characterized in that**
the anode of each parallel-path diode (17) can optionally be set to the potential of a supply voltage ($V_{dd}$) via a pull-up resistor (19) or to the potential of the ground line (9) by a switching element (20).

**8.** Component according to Claim 7,
**characterized in that**
the switching element is a fusible link (20).

**9.** Component according to Claim 8,
**characterized in that**
the fusible link (20) is connected to a fusing input (22).

**10.** Component according to Claim 9,
**characterized in that**
the anode of the parallel-path diode (17) is protected by a series resistor (21).

**Revendications**

**1.** Composant ayant un montage intégré à haute fréquence, qui a un circuit (1) oscillant ayant une capacité (3) d'oscillateur dont la valeur peut être réglée pour un domaine de fréquence prescrit par une diode (3) d'accord,
**caractérisé en ce que** les écarts dus à la fabrication de la fréquence de résonance du circuit (1) oscillant sont compensés par un réseau (12) de conducteurs couplé au circuit (1) oscillant par une capacité (11) de couplage, réseau qui a, montées en série entre des lignes (9, 13) longitudinales, des diodes (17) transversales et des capacités (18) transversales qui peuvent être mises en circuit, respectivement, en parallèle à la capacité d'oscillateur en réglant le point de travail des diodes (17) transversales à l'aide d'un réseau (19, 20, 21) de tension continue commutable.

**2.** Composant suivant la revendication 1,
**caractérisé en ce que** les lignes longitudinales sont formées d'une ligne (13) d'égalisation raccordée au circuit oscillant par la capacité (11) de couplage et d'une ligne (9) à la masse.

**3.** Composant suivant la revendication 2,
**caractérisé en ce que** le potentiel de la ligne (13) d'égalisation est réglé par un diviseur (14, 15) de tension en une valeur comprise entre le potentiel d'une tension ($V_{DD}$) d'alimentation et le potentiel de la ligne (9) à la masse.

**4.** Composant suivant la revendication 2 ou 3,
**caractérisé en ce que** la diode transversale est une diode (17) raccordée par sa cathode à la ligne (13) d'égalisation.

**5.** Composant suivant la revendication 4,
**caractérisé en ce que** la diode transversale est une diode PIN (17).

**6.** Composant suivant l'une des revendications 2 à 5,
**caractérisé en ce que** la capacité transversale est un condensateur (18) raccordé à la ligne à la masse.

**7.** Composant suivant l'une des revendications 2 à 6,
**caractérisé en ce que** l'anode de chaque diode (17) transversale peut être réglée à volonté par une résistance (19) pull-up au potentiel d'une tension ($V_{DD}$) d'alimentation ou par un élément (20) de commutation au potentiel de la ligne (9) à la masse.

**8.** Composant suivant la revendication 7,
**caractérisé en ce que** l'élément de commutation est un pont (20) fusible.

**9.** Composant suivant la revendication 8,
**caractérisé en ce que** le pont (20) fusible est raccordé à une entrée (22) fusible.

**10.** Composant suivant la revendication 9,
**caractérisé en ce que** l'anode de la diode (17) transversale est protégée par une résistance (21) série.